# EUROPÄISCHE PATENTSCHRIFT

(11) **EP 2 455 680 B1**
(45) Veröffentlichungstag und Bekanntmachung des Hinweises auf die Patenterteilung: **04.01.2017**
(21) Anmeldenummer: 11009175.8
(22) Anmeldetag: 18.11.2011
(51) Int. Cl.: F24H 1/14, F24H 9/20, H05B 1/02, H05K 1/02, H05K 7/20, F24H 9/18, H01L 23/40, H01L 23/473

(54) **Elektrischer Durchlauferhitzer**
Electric continuous-flow heaters
Chauffe-eau instantané électrique

(30) Priorität: 19.11.2010 DE 102010051736
(43) Veröffentlichungstag der Anmeldung: 23.05.2012
(73) Patentinhaber: Stiebel Eltron GmbH & Co. KG, 37603 Holzminden (DE)
(72) Erfinder: Heise, Wolfgang, 37603 Neuhaus (DE); Henke, Günter, 37627 Deensen (DE); Diederich, Olaf, 37671 Höxter (DE); Grobe, Michael, 37671 Höxter (DE)

(56) Entgegenhaltungen:
- EP-A2- 2 098 802
- DE-A1- 19 912 236
- DE-U1-202004 012 263
- DE-U1-202007 018 021
- US-A- 4 536 824
- US-A1- 2006 120 039

## Beschreibung

Die vorliegende Erfindung betrifft einen elektrischen Durchlauferhitzer.

Elektrisch betriebene Durchlauferhitzer weisen typischer einen Heizpflock mit mehreren Heizwiderständen auf, welche durch elektronische Schalter aktiviert werden können. Diese elektronischen Schalter können beispielsweise Triacs oder Thyristoren darstellen. Zur Kühlung der elektronischen Schaltelemente kann beispielsweise kaltes zugeführtes Wasser in einem Kühlrohr verwendet werden.

EP 2 098 802 A1 beschreibt einen Durchlauferhitzer mit mehreren Triacs und einem Kühlrohr, durch welches Kaltwasser durchströmt und das zur Kühlung der Triacs verwendet wird. Das Kühlrohr weist zwei gegenüberliegende abgeflachte Kühlflächen auf, an welchen die Triacs zur Kühlung angeordnet werden. Die Triacs sind dabei senkrecht zu einer Leiterplatine angeordnet. Das Kühlrohr kann beispielsweise in einem Walz- oder Pressverfahren hergestellt werden, so dass das Kühlrohr zwei abgeflachte Bereiche aufweist.

Es ist eine Aufgabe der vorliegenden Erfindung, einen Durchlauferhitzer vorzusehen, welcher eine verbesserte Kühlung von den elektronischen Schaltungselementen ermöglicht.

Diese Aufgabe wird durch einen Durchlauferhitzer gemäß Anspruch 1 gelöst.

Vorteile und Ausführungsbeispiele der Erfindung werden nachstehend unter Bezugnahme auf die Zeichnung näher erläutert.
- Fig. 1A und 1B: zeigen zwei perspektivische Ansichten eines Teils eines Durchlauferhitzers gemäß einem ersten Ausführungsbeispiel,
- Fig. 2A und 2B: zeigen einen Teil eines Durchlauferhitzers gemäß einem zweiten Ausführungsbeispiel,
- Fig. 3A - 3C: zeigen verschiedene Ansichten eines Teils eines Durchlauferhitzers gemäß einem dritten Ausführungsbeispiel,
- Fig. 4A und 4B: zeigen zwei perspektivische Ansichten eines Teils eines Durchlauferhitzers gemäß einem vierten Ausführungsbeispiel,
- Fig. 5A - 5C: zeigen ebenfalls verschiedene Ansichten eines Teils eines Durchlauferhitzers gemäß einem fünften Ausführungsbeispiel, und
- Fig, 6A und 6B: zeigen zwei verschiedene Ansichten eines Teils eines Durchlauferhitzers gemäß einem sechsten Ausführungsbeispiel.

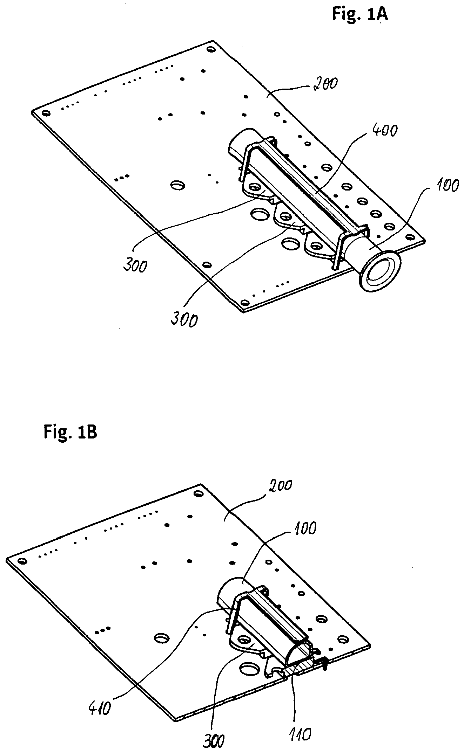

Fig. 1A und 1B zeigen jeweils eine perspektivische Ansicht eines Teils eines Durchlauferhitzers gemäß einem ersten Ausführungsbeispiel. Hierbei weist der Durchlauferhitzer eine Platine bzw. eine Leiterplatte 200, eine Mehrzahl von elektronischen Leistungsschaltelementen (z. B. Triacs oder Thyristoren) 300, ein Kühlrohr 100 und eine Klammer 400 auf, welche zur Befestigung des Kühlrohrs 100 an den Schaltelementen 300 und an der Leiterplatte vorgesehen sind. Die leistungselektronischen Schaltelemente 300 sind liegend auf der Leiterplatte 200 vorgesehen. Vorzugsweise weist die Kühlfläche des leistungselektronischen Schaltelementes 300 nach oben und ein abgeflachter Abschnitt 110 des Kühlrohres 100 wird auf den (Kühlbereich) leistungselektronischen Schaltern platziert. Dadurch, dass das Kühlrohr 100 den abgeflachten Bereich 100 aufweist, der wiederrum auf dem Kühlabschnitt des leistungselektronischen Schalters 300 vorgesehen ist, ist eine effektive Kühlung des leistungselektronischen Schalters vorgesehen. Die Klammer 400 weist vorzugsweise Beine 410 auf, so dass die Klammer 400 über das sich auf dem Triacs befindliche Rohr 110 platziert wird. Die Klammer 400 ist vorzugsweise derart ausgeschaltet, dass das Kühlrohr beziehungsweise der abgeflachte Abschnitt 110 des Kühlrohres auf die Kühlflächen der leistungselektronischen Schaltelemente drückt.

Gemäß dem ersten Ausführungsbeispiel sind die leistungselektronischen Schaltelemente flach bzw. liegend auf einer Leiterplatte 200 platziert. Optional weist hierbei die Kühlfläche der leistungselektronischen Schalter nach oben. Auf den flachliegenden leistungselektronischen Schaltern wird ein Kühlrohr 100 platziert, optional wird der abgeflachte Abschnitt 110 des Kühlrohrs 100 auf die Kühlflächen der leistungselektronischen Schaltelemente gedrückt.

Die Anschlüsse des leistungselektronischen Schalters können durch die Leiterplatte geführt oder das leistungselektronische Schaltelement kann als ein SMD-Bauteil ausgeführt werden.

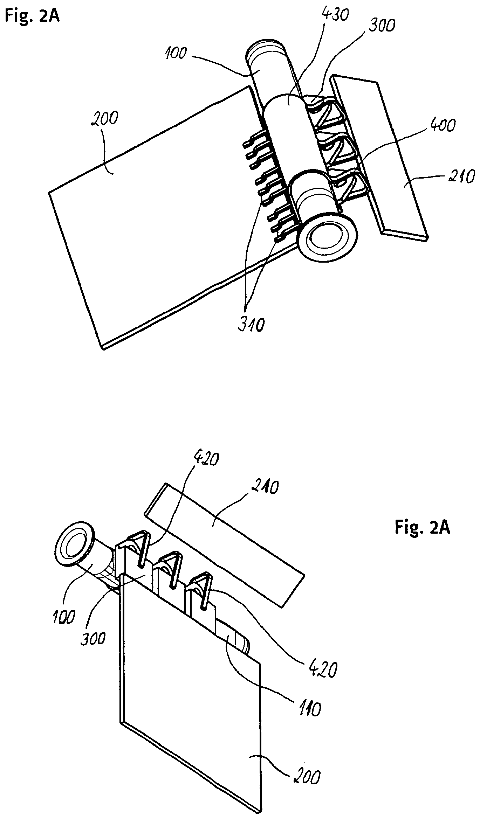

Fig. 2A und 2B zeigen jeweils eine perspektivische Ansicht eines Teils eines Durchlauferhitzers gemäß einem zweiten Ausführungsbeispiel. Der Durchlauferhitzer weist eine Leiterplatte 200 auf, auf welcher eine Mehrzahl leistungselektronischer Schaltelemente 300 vorgesehen werden kann. Vorzugsweise sind die leistungselektronischen Schaltelemente flach auf der Leiterplatte 200 platziert. Gemäß dem zweiten Ausführungsbeispiel kann die Kühlfläche der leistungselektronischen Schalter 300 auf der Leiterplatte platziert werden. Die Leiterplatte weist vorzugsweise einen abtrennbaren Abschnitt 210 auf, auf welchem die leistungselektronischen Schaltelemente platziert werden können. Anschließend kann der abtrennbare Abschnittspfad entfernt werden und ein Kühlrohr 100 kann mit seinem abgeflachten Abschnitt 110 auf den leistungselektronischen Schaltelementen 300 platziert werden. Zur weiteren Befestigung des Kühlrohres auf den leistungselektronischen Schaltelementen 300 kann eine Klammer 400 verwendet werden. Hierbei kann ein Arm 420 der Klammer 400 auf der Rückseite der leistungselektronischen Schaltelemente 300 platziert werden. Ein weiterer vorzugsweise runder Abschnitt 430 der Klammer 400 kann auch auf dem Kühlrohr 100 platziert werden.

Gemäß dem zweiten Ausführungsbeispiel kann die Leiterplatte als eine Montagehilfe verwendet werden.

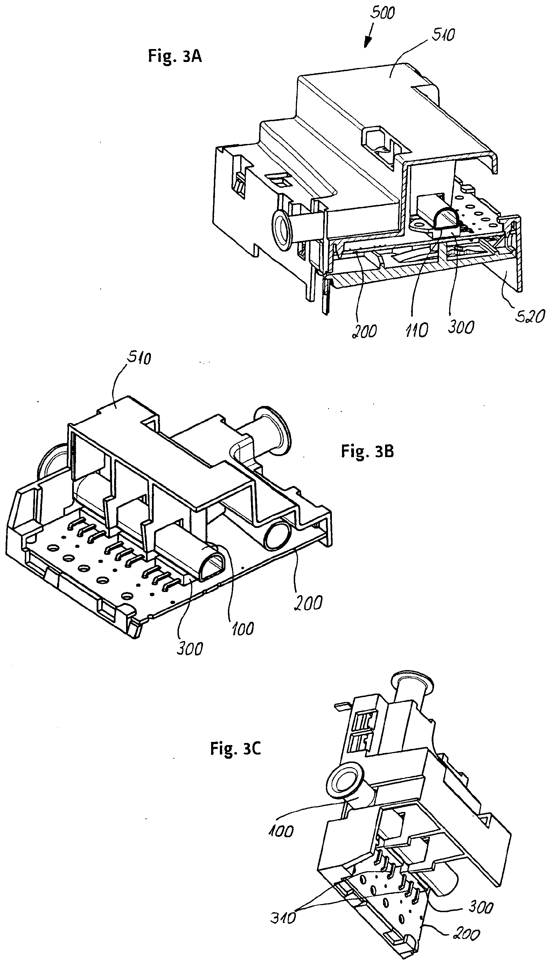

Fig. 3A - 3C zeigen eine perspektivische Schnittansicht sowie zwei perspektivische Ansichten eines Teils eines Durchlauferhitzers gemäß einem dritten Ausführungsbeispiel. Hierbei weist der Durchlauferhitzer eine Leiterplatte 200, eine Mehrzahl von leistungselektronischen Schaltelementen 300 und ein Kühlrohr 100 auf. Die leistungselektronischen Schaltelemente 300 werden flach auf der Leiterplatte platziert und das Kühlrohr 100 mit seinem abgeflachten Abschnitt 110 wird dann wiederrum auf dem leistungselektronischen Schaltelement platziert, so dass eine Sandwich-Anordnung erreicht wird. Ferner weist der Durchlauferhitzer ein Gehäuse 500 mit einem Gehäuseoberteil 510 und einem Gehäuseunterteil 520 auf.

In Fig. 3B ist lediglich das Gehäuseoberteil gezeigt, so dass sowohl die Leiterplatte 200 als auch das Kühlrohr 100 und die leistungselektronischen Schaltelemente 300 gezeigt sind.

In Fig. 3C ist lediglich gezeigt, dass hierbei die Anschlüsse 310 der leistungselektronischen Schaltelemente 300 aus der Leiterplatte rausfahren. Somit ist ein Gehäuse vorgesehen, welches das Kühlrohr umschließt. Ferner kann das Kühlrohr füllfrei auf den leistungselektronischen Schaltelementen platziert werden. Gemäß dem dritten Ausführungsbeispiel wird keine Klammer benötigt.

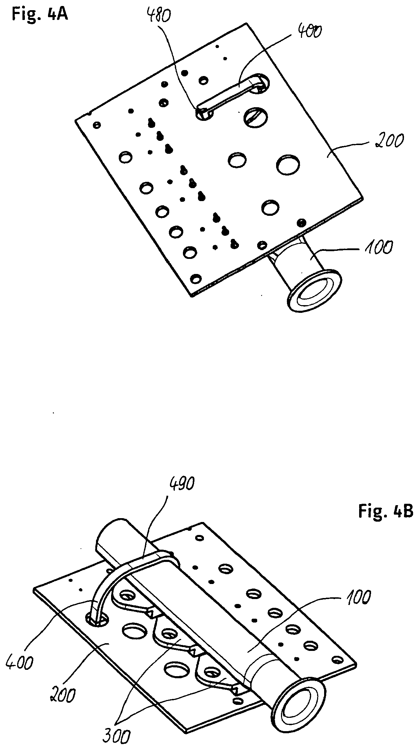

Fig. 4A und 4B zeigen zwei verschiedene perspektivische Ansichten eines Durchlauferhitzers gemäß einem vierten Ausführungsbeispiel. Der Durchlauferhitzer weist eine Leiterplatte 200, eine Mehrzahl von leistungselektronischen Schaltelementen 300 und mindestens eine Klammer 400 auf. In der Leiterplatte 200 kann beispielsweise unterhalb oder oberhalb eines der leistungselektronischen Schalter 300 ein Loch 220 vorgesehen sein. Die Klammer 400 kann einen ersten und zweiten Arm 480, 490 aufweisen, wobei der erste Arm 480 in das Loch 220 eingreifen kann und der zweite Arm 490 auf dem Kühlrohr derart liegen kann, dass das Kühlrohr beispielsweise mit seinem abgeflachten Bereich 110 auf die leistungselektronischen Schaltelemente gedrückt wird.

Die Klammer kann als ein Federelement ausgestaltet sein, so dass ein Druck auf das Kühlrohr 100 und die leistungselektronischen Schalter ausgeübt werden kann. Die Klammer 400 kann ebenfalls optional als ein Teil des Gehäuses ausgestaltet sein.

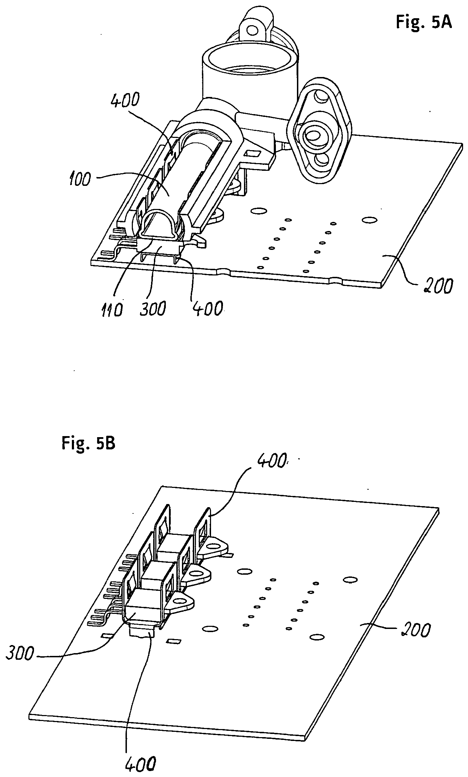

Fig. 5A - 5C zeigen verschiedene Ansichten eines Teils eines Durchlauferhitzers gemäß einem fünften Ausführungsbeispiel. In Fig. 5A ist eine perspektivische Schnittansicht gezeigt. Hierbei werden leistungselektronische Schaltelemente 300 mittels einer Klammer 400a auf einer Leiterplatte 200 befestigt. Auf den leistungselektronischen Schaltelementen 300 kann ein Kühlrohr 100 mit einem abgeflachten Abschnitt 110 platziert werden. Das Kühlrohr 100 kann ebenfalls durch die Klammer 400a gehalten werden.

Der abgeflachte Abschnitt 110 des Kühlrohres 100 ist dabei derart ausgestaltet, dass er breiter ist als der Querschnitt des Kühlrohres 100, das heißt es kann also links und rechts einen Wulst aufreisen. Dies ist insbesondere hinsichtlich einer erhöhten Kühlleistung vorteilhaft.

Fig. 5B zeigt die Leiterplatte 200 mit den Klammern 400a und den sich darauf befindlichen leistungselektronischen Schaltelementen 300.

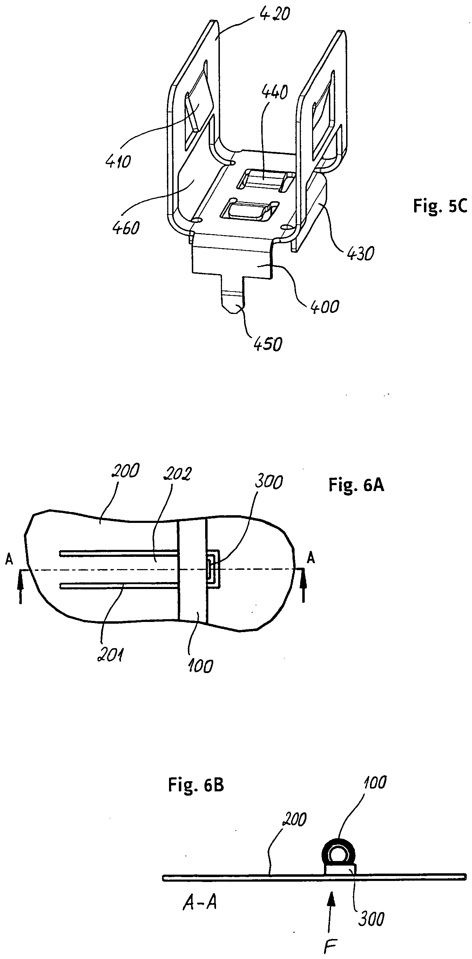

Fig. 5C zeigt eine perspektivische Ansicht der Klammern 400a. Die Klammer 400a weist zwei erste Arme 420 sowie zwei zweite Arme 450 auf. Mittels der zweiten Arme 450 kann die Klammer 400 in bzw. an der Leiterplatte 200 befestigt werden. Die leistungselektronischen Schaltelemente 300 können in Ausnehmungen 460 in den ersten Armen 420 eingeschoben werden. Im oberen Bereich der ersten Arme 420 ist jeweils eine Nase 410a vorgesehen, welche zur Aufnahme und Halten des Kühlrohres 100 dienen. In einem mittleren Abschnitt 430 sind vorzugsweise Nasen 440a vorgesehen, auf welchen die leistungselektronischen Schaltelemente platziert werden können. Vorzugsweise werden die leistungselektronischen Schaltelemente derart platziert, dass ihre Kühlfläche nach oben zeigt, so dass der abgeflachte Abschnitt 110 des Kühlrohres darauf platziert werden kann, um eine maximale Kühlleistung zu ermöglichen.

Fig. 6A und 6B zeigen zwei verschiedene Ansichten eines Durchlauferhitzers gemäß einem sechsten Ausführungsbeispiel. Der Durchlauferhitzer gemäß dem sechsten Ausführungsbeispiel kann auf dem Durchlauferhitzer gemäß dem ersten, zweiten, dritten, vierten und/oder fünften Ausführungsbeispiel beruhen. In Fig. 6A und 6B sind eine Leiterplatte 200, ein leistungselektronisches Schaltelement 300 und ein Kühlrohr 100 gezeigt. Die Leiterplatte 200 weist einen Freischnitt 201 auf, welcher im Wesentlichen U-förmig ausgestaltet ist, so dass eine Leiterplattenzunge 202 vorgesehen ist. An dem freien Ende der Leiterplattenzunge 202 kann ein leistungselektronisches Schaltelement 300 vorgesehen sein. Auf dem leistungselektronischen Schaltelement 300 kann ein Kühlrohr 100 zum Kühlen des leistungselektronischen Schaltelementes 300 vorgesehen sein. Die Leiterplattenzunge 202 ist somit flexibel. Mittels einer Feder, einer Klammer oder eines Gehäuseteils kann eine Andruckkraft F auf die Leiterplattenzunge 202 aufgebracht werden.

Da die Leiterplattenzunge 202 flexibel ist, wird eine Kraft F, die auf sie wirkt, auf die leistungselektronischen Schaltelemente übertragen und diese vorzugsweise auf das Kühlrohr 100 gedrückt. Somit ist das Kühlrohr 100 an einem anderen Teil befestigt, als die leistungselektronischen Schaltelemente oder die Leiterplatte 200. Durch die Flexibilität der Leiterplattenzunge 202 werden weiterhin Toleranzen der Bauteile ausgeglichen. Vorzugsweise ist das Kühlrohr 100 an einem Bauteil des Durchlauferhitzers gehalten. Eine Kraft F wird mittels einer Feder, einer Klammer oder eines anderen Bauteils des Durchlauferhitzers auf die Leiterplattenzunge 202 aufgebracht. Die Leiterplattenzunge 202 verformt sich aufgrund ihrer Flexibilität und wirkt auf das leistungselektronische Schaltelement 300, so dass dieses gegen das Kühlrohr 100 gedrückt wird. Vorteilhafterweise ist eine Klammer 400 zu verwenden um die Kraft F zu erzeugen.

Fig. 6B zeigt eine Schnittansicht entlang des Schnitts A - A von Fig. 6A. Hierbei ist insbesondere zu sehen, dass ein leistungselektronisches Schaltelement 300 auf der Leiterplatte 200 vorgesehen ist und dass auf dem leistungselektronischen Schaltelement 300 ein Kühlrohr 100 vorgesehen ist.

## Patentansprüche

1. Elektrischer Durchlauferhitzer, mit
einer Mehrzahl von leistungselektronischen Schaltelementen (300) zum Schalten von Heizelementen des Durchlauferhitzers,
einem Kühlrohr (100), durch welches während des Betriebs Kaltwasser fließt, zum Kühlen der Mehrzahl der leistungselektronischen Schaltelemente (300) und
einer Leiterplatte (200), **dadurch gekennzeichnet, dass** auf der Leiterplatte (200) die leistungselektronischen Schaltelemente (300) flach oder liegend platziert sind,
wobei das Kühlrohr (100) auf dem flachen oder liegenden leistungselektronischen Schaltelement platziert ist.

2. Durchlauferhitzer nach Anspruch 1, wobei
die leistungselektronischen Schaltelemente (300) eine erste und eine zweite Seite aufweisen, wobei die erste Seite die Kühlfläche der leistungselektronischen Schaltelemente darstellt und die leistungselektronischen Schaltelemente mit ihrer zweiten Seite auf einer Leiterplatte (200) platziert sind,
wobei das Kühlrohr (100) einen ersten abgeflachten Abschnitt (110) aufweist, der auf der ersten Seite der leistungselektronischen Schaltelemente (300) platziert wird, um die leistungselektronischen Schaltelemente (300) zu kühlen.

3. Durchlauferhitzer nach Anspruch 1 oder 2, ferner mit
einer Klammer (400) zum Halten zumindest des ersten abgeflachten Abschnitts (110) des Kühlrohres (100) auf der ersten Seite der leistungselektronischen Schaltelemente,
wobei die Klammer (400) Beine aufweist, welche in die Leiterplatte (200) eingreifen.

4. Durchlauferhitzer nach einem der Ansprüche 1 bis 3, wobei eine Klammer (400) zum Halten des Kühlrohres (100) auf den leistungselektronischen Schaltelementen einen ersten und zweiten Arm (190, 490,480) aufweist, wobei der erste Arm (490) auf dem Kühlrohr (100) platziert wird und der zweite Arm unter die Leiterplatine (200) eingreift.

5. Durchlauferhitzer nach einem der Ansprüche 1 bis 3, wobei die Leiterplatte (200) eine Leiterplattenzunge (202) mit einem Freischnitt (201) aufweist, wobei die leistungselektronischen Schaltelemente (300) auf dem freien Ende der Leiterplattenzunge (202) platziert sind.

## Claims

1. Electrical instant water heater with
a number of electronic switching elements (300) for switching the heating elements of the instant water heater,
a cooling pipe (100), through with cold water flows during operation to cool the number of electronic switching elements (300) and
a conductor plate (200), **characterized by** the fact that the power electronic switching elements (300) are placed flat or recumbent on the conductor plate (200),
whereby the cooling pipe (100) is placed on the flat or recumbent electronic switching element.

2. Instant water heater pursuant to claim 1, whereby
the electronic switching elements (300) display a first and second side, whereby the first side represents the cooling surface of the electronic switching element, and the second side of the electronic switching element is placed on a conductor plate (200),
whereby the cooling pipe (100) has a first flat section (110), which is placed on the first side of the electronic switching element (300), in order to cool the electronic switching element (300).

3. Instant water heater pursuant to claim 1 or 2, additionally with
a bracket (400) to hold at least the first flat section (110) of the cooling pipe (100) on the first side of the electronic switching element,
whereby the bracket (400) has legs which grasp the conductor plate (200).

4. Instant water heater pursuant to one of the claims 1 to 3, where there is a bracket (400) to hold the cooling pipe (100) on the electronic switching element which has a first and second arm (190, 490, 480), where the first arm (490) is placed on the cooling pipe (100) and the second arm is grasps under the conductor plate (200).

5. Instant water heater pursuant to one of the claims 1-3, whereby the conductor plate (200) has a conductor plate tongue (202) with a free punch (201), whereby the electronic switching element (300) is placed on the free end of the conductor plate tongue (202).

## Revendications

1. Chauffe-eau électrique instantané avec
plusieurs éléments de commutation électroniques de puissance (300) pour la commutation d'éléments de chauffage du Chauffe-eau instantané,
un tube de refroidissement (100), à travers lequel de l'eau froide s'écoule pendant le fonctionnement, afin de refroidir les éléments de commutation électroniques de puissance (300) et
un circuit imprimé (200), **caractérisé en ce que** les éléments de commutation électroniques de puissance (300) sont disposés à plat ou allongés sur le circuit imprimé (200),
sachant que le tube de refroidissement (100) est placé sur l'élément de commutation électronique de puissance à plat ou allongé.

2. Chauffe-eau instantané selon la revendication 1, sachant que
les éléments de commutation électroniques de puissance (300) présentent un premier et un deuxième côté, sachant que le premier côté représente la surface froide des éléments de commutation électroniques de puissance et que les éléments de commutation électroniques de puissance sont placés avec leur deuxième côté sur un circuit imprimé (200),
sachant que le tube de refroidissement (100) présente une première section aplatie (110) qui est placée sur le premier côté des éléments de commutation électroniques de puissance (300) afin de refroidir les éléments de commutation électroniques de puissance (300).

3. Chauffe-eau instantané selon la revendication 1 ou 2, en outre avec
une agrafe (400) pour le maintien d'au moins da première section aplatie (110) du tube de refroidissement (100) sur le premier côté des éléments de commutation électroniques de puissance,
sachant que l'agrafe (400) présente des jambes qui entrent dans le circuit imprimé (200).

4. Chauffe-eau instantané selon l'une des revendications 1 à 3, sachant qu'une agrafe (400) pour le maintien du tube de refroidissement (100) sur les éléments de commutation électroniques de puissance présente un premier et un deuxième bras (190, 490,480), sachant que le premier bras (490) est placé sur le tube de refroidissement (100) et le deuxième bras entre sous le circuit imprimé (200).

5. Chauffe-eau instantané selon l'une des revendications 1 à 3, sachant que le circuit imprimé (200) présente une languette (202) avec une section libre (201), sachant que les éléments de commutation électroniques de puissance (300) sont placées sur l'extrémité libre de la languette du circuit imprimé (202).
